# EUROPEAN PATENT SPECIFICATION

(11) **EP 0 766 604 B1**
(45) Date of publication and mention of the grant of the patent: **18.09.2002**
(21) Application number: 95923984.9
(22) Date of filing: 19.06.1995
(51) Int. Cl.: B05D 1/12, B05D 1/04, B05C 11/02

(54) **METHOD AND APPARATUS FOR CONTROLLED PARTICLE DEPOSITION ON WAFERS**
VERFAHREN UND VORRICHTUNG ZUM KONTROLLIERTEN AUFBRINGEN VON PARTIKELN AUF WAFERS
PROCEDE ET APPAREIL DE DEPOT REGULE DE PARTICULES SUR DES PLAQUETTES

(30) Priority: 21.06.1994 US 263128
(43) Date of publication of application: 09.04.1997
(73) Proprietor: MSP CORPORATION, Minneapolis MN 55414 (US)
(72) Inventor: LIU, Benjamin Y.H., North Oaks, MN 55110 (US)
(74) Representative: McLeish, Nicholas Alistair Maxwell
(86) International application number: PCT/US95/07790
(87) International publication number: WO 95/035167

(56) References cited:
- US-A- 4 928 537
- US-A- 5 038 711
- US-A- 5 194 297
- US-A- 5 306 345
- JOURNAL OF THE IES, Vol. 35, No. 6, November/December 1992, S. CHAE et al., "Size Response Characteristics of a Wafer Surface Scanner for Nonideal, Real-World Particles", pages 45-52.
- AEROSOL SCIENCE AND TECHNOLOGY, Vol. 6, June 1987, B.Y.H. LIU et al., "Particle Deposition on Semiconductor Wafers", pages 215-224.

## Description

### BACKGROUND OF THE INVENTION

The present invention relates to a system for depositing particles of known size from a supply thereof onto a surface, e.g. of a wafer, according to the precharacterising part of claim 1.

The invention further relates to a method of operating a system according to claim 1.

A system of this type is known from e.g. US-A-5 194 297.

In the semiconductor industry, it is often necessary to determine the number of particles on a wafer by use of a wafer inspection tool. Such tools generally operate on the principle of light scattering, which measures the particle size on the wafer by the amount of light scattered by each particle as a laser beam is swept across the wafer surface. To standardize such an inspection tool it is necessary to deposit particles of a known size on a wafer and place the wafer in the inspection tool to determine the response from the reference wafer particles, for comparison with known factory settings of the inspection tool. It is also important to know the number of particles on the wafer, and to have a reasonably uniform distribution of particles on the wafer surface. This will essentially be a calibration process to ensure that the results obtained from the wafer inspection tool are accurate or in some way can be correlated to standard readings.

In addition, the original calibration of the inspection tool in the factory is also based on the use of known size particles on a wafer. The most commonly used calibration particles are polystyrene latex (PSL) spheres, usually in the size range between 0.1 µm and 2 µm. Also, there is a need to deposit uniform size particles of silicon, silicon dioxide, silicon nitride and similar materials on wafers, to determine the response of the inspection tool to particles of a different material. See for example the article by S.A. Chae, H.S. Lee and B.Y.H. Liu "Size Response Characteristics Of A Wafer Surface Scanner for Non-Ideal, Real-World Particles" Journal of the IES 35(6):45-52, December 1992.

A commonly used method of depositing such standard calibration particles on a wafer is to make a suspension of the particles, such as PSL, in water, and then atomize the suspension to form a spray. The spray is allowed to dry leaving uniform sized PSL particles suspended in air to form an aerosol. The aerosol is then introduced into a chamber that holds the wafer to permit these particles to deposit on the wafer surface. The mechanism that causes particles to deposit on a wafer from an aerosol are well known. Theoretical and experimental studies have shown that the principal deposition mechanisms are gravitational settling, and diffusion. If the particles are electrically charged, electrostatic attraction also plays a role in particle deposition. See the article by B.Y.H. Liu and K.H. Ahn, entitled "Particle Deposition on Semiconductor Wafers," Aerosol Sci. Technol. 6:215-224 1987 and the article by D.Y.H., Pui, et al. "Experimental Study of Particle Deposition on Semiconductor Wafers, "Aerosol Science and Technology 12:795-804, 1990.

U.S. Patent 5,038,711 discloses an epitaxial facility in which reaction and scavenging gases are delivered into a reaction chamber and reaction particles are subsequently removed. U.S. Patent 5,306,345 discloses a deposition chamber which can accommodate wafers for deposition of particles onto wafers.

To carry out the deposition in a chamber containing a wafer by the simple introduction of an aerosol into the chamber has a number of disadvantages. First, when the wafer is placed in the chamber, the uncontrolled contaminate particles already in the chamber can deposit on the wafer to cause unwanted contamination of the wafer. Second, when the aerosol is first introduced into the chamber, the particle concentration in the chamber will build up slowly as the aerosol is mixed with the relatively clean chamber air. The rate of particle deposition, therefore, will vary as a function of time due to the varying particle concentration. The varying particle concentration makes it difficult to control the number of particles deposited on the wafer. Similarly, when the aerosol flow into the chamber is stopped, the particle concentration in the chamber will slowly decay, again causing variations in particle deposition rate with time and making it difficult to control or know the number of particles deposited.

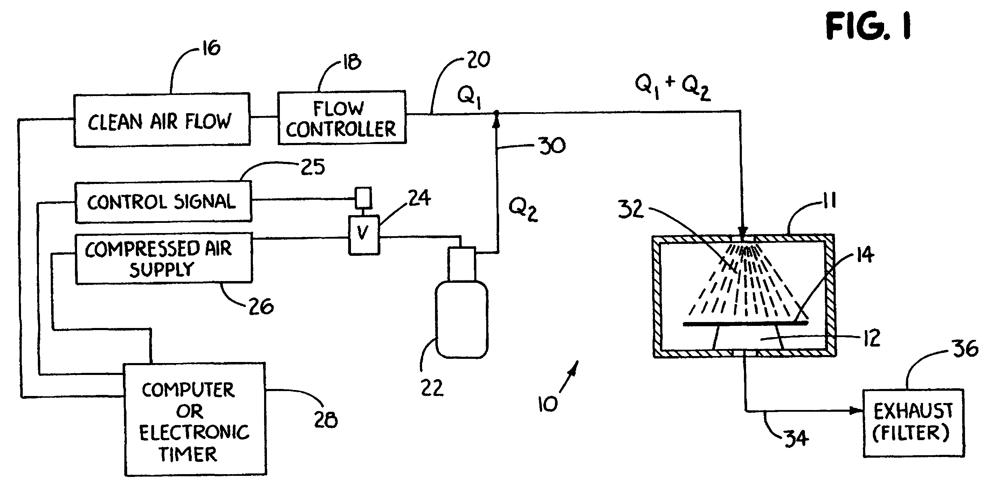

U.S. Patent No. 5,194,297 entitled "SYSTEM AND METHOD FOR ACCURATELY DEPOSITING PARTICLES ON A SURFACE by Bradley H. Scheer, et al. discloses in Fig. 1 a method of depositing particles on a surface. The system disclosed employs a deposition chamber within which particles can be deposited onto a surface of for example semi conductor wafters, and a second chamber within the deposition chamber. Through said second chamber a clear gas can flow down across wafers in what is referred to as a sheath flow. Wafers are physically moved between a clean sheath flow area and a deposition area by a conveyor arrangement. Thus there is an area where there is clean air providing a sheath over the wafer, and a separate aerosol flow area. The wafer is first introduced into the clean sheath flow area prior to deposition, and is protected from deposition of particles when in the clean sheath flow chamber. The wafer is then moved mechanically into the aerosol flow area for deposition, and then back to the clean sheath flow area following deposition, to complete the cycle. Mechanical movement of the wafer is complicated, and can cause unwanted contaminate particles to be generated by the mechanical movement of a conveyor belt, a robot arm or other gear mechanism needed to move the wafer between the two areas.

The present invention seeks to overcome the problems inherent in accurately depositing known size particles onto a surface, e.g. a wafer, without introducing unwanted contaminates, in a simple, easily controlled manner.

### SUMMARY OF THE INVENTION

The present invention provides a system for depositing particles of known size from a supply thereof onto a surface, e.g. of a wafer, the system comprising a deposition chamber having an inlet and an outlet; a support provided in the deposition chamber for mounting a wafer or other element thereon; a source of clean gas coupled for introduction of clean gas into the deposition chamber; supply means for supply of a gas in the form of an aerosol comprising said particles of known size, the supply means being coupled to direct said gas into the deposition chamber for deposition of said particles as aforesaid; and means for controlling the flows of the clean gas and said gas comprising said particles; characterised in that the source of clean gas and the supply means are coupled to the one inlet for introduction of clean gas and/or said gas into the chamber and in that the clean gas, during operation of the system, purges unwanted impurities before and after introduction of said gas comprising said particles into the chamber.

Particular embodiments of the invention are the subject of the respective dependent claims.

It is preferred that said means for controlling the flow of the clean gas and said gas comprising said particles provides a clean gas flow towards the support, and a wafer when mounted thereon, to purge unwanted impurities therefrom; said supply means supplies said gas in the form of an aerosol for a predetermined time in order to deposit a predetermined number of said particles as aforesaid; and said means for controlling said flows admixes the flows for a predetermined period of time to deposit the predetermined number of particles and thereafter to direct the clean gas into the deposition chamber to purge the chamber.

The present invention also provides a method of operating a system according to claim 1 such that a predetermined number of said particles can be deposited into the deposition chamber for deposition onto the surface of a semiconductor wafer or other surface when provided on said support, the method comprising the steps of directing a clean gas flow through said inlet into the deposition chamber and at such surface to purge unwanted particles therefrom; directing said gas flow containing said particles through said inlet into the deposition chamber for a predetermined time to deposit a desired number of particles onto said surface and then discontinuing the gas flow containing said particles; and directing a clean gas flow into the chamber for a selected time after discontinuing gas flow containing said particles, and prior to removal of a wafer from the deposition chamber when a wafer is mounted on the support.

Particular embodiments of the invention are the subject of the respective dependent claims.

A system according to a preferred embodiment of the present invention, in its simplest form, provides a chamber in which a wafer can be supported in a known manner, and initially provides a source of clean particle free gas, such as air or dry nitrogen which purges the chamber of unwanted particles, making the chamber clean and particle free. A wafer is placed into the chamber, and clean air flow can be combined with an atomizer flow carrying known size particles at the inlet of the chamber. Thus there is a mixing of the aerosol containing the known size particles and the clean air flow that is introduced into the chamber. The aerosol stream mixed with the clean air flow impinges the wafer surface in the chamber to cause particle deposition. The exhaust air flow from the chamber is usually filtered through a high efficiency filter to prevent the discharge of aerosols into the ambient clean room environment.

After a predetermined time of particle deposition, the atomizer is turned off, utilizing means in the form of valves that can be manually controlled, or through an electronic timer or a computer, so that the aerosol flow stops, and the air or gas flow entering the chamber again is original clean air flow. The clean air flow impinges directly on the wafer and thus provides a protective clean air layer to prevent further particle deposition on the wafer surface. This is particularly helpful where some particles may otherwise remain in the chamber.

The aerosol flow can be turned on and off quickly, so that the number of particles deposited on the wafer can be accurately controlled. The supply means for the aerosol gas, including the atomizer forming the particle source can be turned off when particles are not to be deposited, which conserves such materials and the attendant cost.

In a modified form of the invention, the total flow into the chamber is maintained at a known level, even after the aerosol flow has been added to the clean gas flow on the inlet side of the chamber. This makes for a less turbulent air flow in the chamber. Additionally, an electrostatic charge can be applied to the particles, to improve the performance of the particle deposition system.

A very precise control over the particle size can be achieved by adding an electrical aerosol switch which will deflect particles of the desired diameter to the vicinity of a slit opening near the bottom of the switch housing, and then sweeping these particles out of the switch and into the deposition chamber.

The electrical aerosol switch in and of itself is known, but combined with the clean air flow and switching the known size particles into or out of a steady air stream of clean flow provides for a very precise deposition time control.

### BRIEF DESCRIPTION OF THE DRAWINGS

Figure 1 is a schematic representation of a basic particle deposition system made according to the present invention;
Figure 2 is a modified form of the system of Figure 1 illustrating a flow control device for input air flow to a deposition chamber;
Figure 3 is a further modified form of the invention providing electrostatic charge to aerosol particles being deposited on a wafer; and
Figure 4 shows a deposition system made according to the present invention with an electrical particle switch on the input side of the deposition chamber to precisely control the timing of the introduction of particles into a deposition chamber.

### DETAILED DESCRIPTION OF THE PREFERRED EMBODIMENTS

Referring to Figure 1, a basic system according to the present invention is illustrated generally at 10 and comprises a deposition chamber 11 which has a support 12 therein for supporting a wafer or object 14 onto an upper surface of which particles are to be deposited. The chamber construction normally will be in a clean room. This depositing arrangement is to provide a known number of particles (within reasonable limits), of a known size and density on a wafer that can be used for calibration purposes or for comparison with wafers in use to determine the particle distribution on such wafers. Various forms of the chamber can be utilized. The deposition system 10 further includes a source of clean air flow indicated generally at 16. It is understood that the source can include other gases as well as air, such as dry nitrogen. If desired, control means in the form of a flow controller 18 can be put on the outlet line of the clean air flow source 16, to provide a flow of air along a line 20 indicated at Q₁. This provides a known flow of clean gas or air, which does not have any contaminating particles.

Supply means in the form of an atomizer indicated at 22 is used for providing known size particles, such as the PCL particle previously mentioned. The atomizer provides an aerosol, when compressed air is directed into the atomizer 22 through control means provided by a solenoid valve 24 from a source of clean compressed air 26. The solenoid valve 24 can be controlled by a control signal represented at 25 provided by an electronic timer or a computer 28. The timer or computer 28 also can control provision of the clean air flow from source 16 by operating a suitable valve.

The outlet line 30 from the atomizer 22 is connected to the line 20, downstream from the flow control means provided by a controller 18, but between the flow controller and the deposition chamber 11. An atomizer flow Q₂ is provided on line 30. As can be seen, the line 20 has an inlet connection into the interior of the deposition chamber 11. When the valve 24 is energized by providing a control signal 25 from the timer or the computer 28, the atomizer 22 will discharge a known volume of air bearing particles that have been generated in a known manner to ensure an adequate aerosol flow Q₂. The flow along the line 20 between the junction with line 30 and the deposition chamber 11 in this form of the invention will have a total flow Of Q₁ + Q₂, and will be carrying particles into the chamber. These particles will be directed as indicated at 32 within the interior of the chamber down onto the upwardly facing surface of the wafer 14.

Undeposited particles will be purged out through line 34 through an exhaust and filter arrangement 36.

In the method of operating the system shown in Figure 1, air flow from source 16 is first turned on, and again it is a source of particle free gas or air obtained in a known manner. The clean air flow into the deposition chamber 11 is permitted to purge the chamber of unwanted particles, until it is known that the chamber is clean and particle free. These unwanted particles will be discharged out through the exhaust line 34 and the exhaust and filter arrangement 36. Sufficient initial clean air flow is provided for a sufficient length of time to ensure that the unwanted particles in the chamber 11 have been purged.

Then, wafer 14 is placed in the chamber on support 12 (this can be any suitable support and is shown only schematically). The clean air flow can continue during the installation of the wafer to keep the chamber volume free of particles. The solenoid valve 24 is energized after the wafer is installed and the chamber closed, which starts the aerosol flow Q₂ of known size and volume of particles. The flow Q₂ enters the line 20 and mixes with the clean air flow Q₁ to form a combined aerosol stream Q₁ + Q₂ that is passed into the chamber 11, and is directed toward the upward surface of the wafer 14 on which the particles are to be deposited. The aerosol stream impinges on the wafer in the chamber 11 to cause the particle deposition in the chamber 11. The exhaust air flow is through a filter, which is preferably a high efficiency filter, to prevent the discharge of the aerosol into the ambient clean room environment in which these processes normally take place.

After a predetermined time period of particle deposition the atomizer 22 is turned off by turning off valve 24, either manually or with an electrical signal from a precision timer or computer 28. The aerosol flow Q₁ will stop and flow entering the chamber 11 is then again restored to its original clean air or gas flow Q₁. Since the clean air flow is impinging directly on the wafer 14, as shown, it provides a protective clean air layer to prevent further particle deposition on the wafer surface from particles that may remain in the chamber 11 at least for a short period of time. When the wafer 14 has been left for a sufficient period of time to ensure that a clean air layer is flowing on the wafer, it can be removed from the deposition chamber 11 for use in an analysis instrument, or for any other use that may be desired. The wafer does not have to be shifted from its original position within the chamber 11, and yet receives a direct impingement of clean sheath air while it is being placed into the chamber. The wafer will be in a purged clean, particle free chamber to prevent contaminants from depositing thereon. After the deposition time, which can be relatively accurately controlled, the wafer 14 can be removed and then will have a known number of particles of a known size on it.

The aerosol flow switching method disclosed has the further advantage of having atomizer 22 turned on only for the short time duration when the aerosol is needed for deposition. During the remaining time the atomizer 22 is left idle, to reduce the amount of liquid suspension that must be atomized to form an aerosol, leading to a savings in both material and cost. The fact that the atomizer 22 is turned on only when needed for deposition of particles on a wafer also minimizes the unwanted particle build-up on the interior surfaces of the deposition system, making it unnecessary to take the system apart for frequent cleaning.

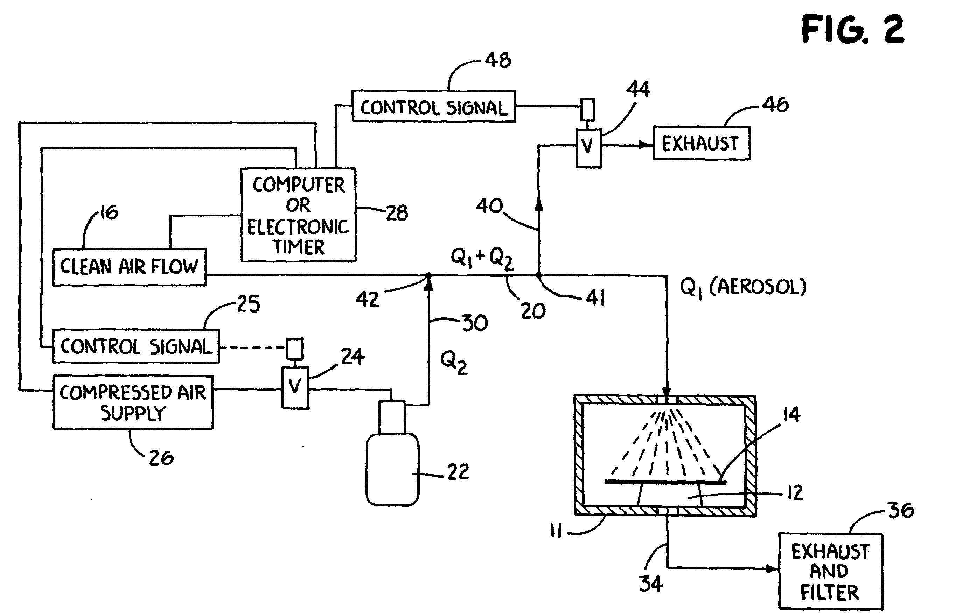

Figure 2 shows a modified system for obtaining a more precise flow into the deposition chamber 11 by avoiding flow disturbances. The system of Figure 1 shows the flow into the chamber 11 when the atomizer 22 is turned on, that is, the total flow into the deposition chamber 11 will be Q₁ + Q₂, and when the clean air flow only is flowing into the chamber 11 the flow is only Q₁. Figure 2 shows a way of avoiding flow disturbances caused by changing flow volumes. In Figure 2 the same components are numbered the same, and include the aerosol chamber 11, the support 12 on which wafer 14 is mounted. The exhaust line 34 and inlet line 20 are numbered the same.

A bleed line 40 to line 20 is connected to the line 20 at a junction or "T" fitting 41 that is downstream from a connection 42 between the line 30 and the line 20. The line 30 carries the aerosol whenever the solenoid valve 24 is energized, as previously explained.

The line 40 is connected through a second solenoid valve 44 to an exhaust arrangement 46 that also can have a filter if desired. The valve 40 is energized and de-energized or controlled by a control signal 48 from the electronic timer or computer 28 which synchronizes the controls for the control signal 25 operating the solenoid valve 24. After the atomizer 22 is turned on by energizing solenoid valve 24, the aerosol flow is mixed with the clean air flow Q₁ at junction 42, as before, and solenoid valve 44 is opened and controlled as to its port size (it can be a flow control valve) diverting part of the mix flow Q₁ + Q₂ at junction 41. The diverted flow equal to Q₂, is exhausted through the exhaust arrangement 46. The combined stream is thus divided, and the portion of the line 20 downstream, and that is in direction toward deposition chamber 11, from junction 41 will continue to have a flow volume Q₁, but it will be an aerosol flow. The total flow into the chamber 11 is thus kept constant at Q₁ at all times.

The method is the same as before, with the deposition chamber 11 being purged by a clean air or gas flow from source 16 under control of timer or computer 28, and when the deposition chamber 11 has been purged so that there are no foreign particles in the chamber, the wafer 14 or other object on which deposition of particles is to take place is moved onto support 12. Then the solenoid valve 24 will be opened to provide aerosol flow Q₁ along line 30, and valve 44 will be also open, at an appropriate time, to control the total flow coming through line 20 between junction 41 and the deposition chamber 11 at a volume of Q₁ but with aerosols in that volume.

The timing of course can again be carried out as previously explained to stop the atomizer flow at the desired time so that the deposition on the wafer will be as desired.

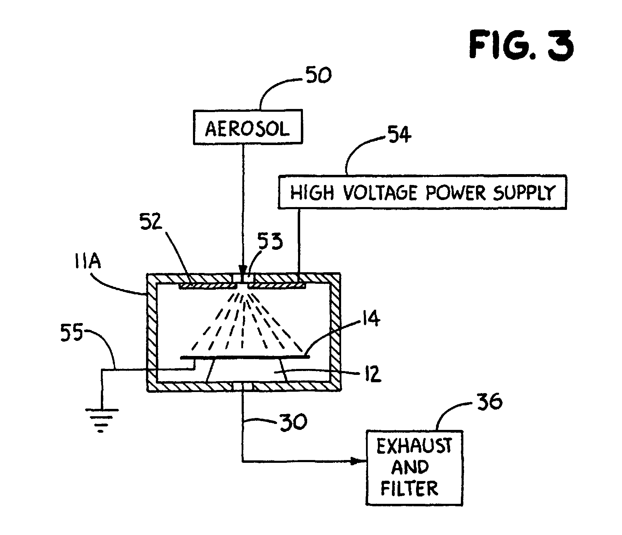

Figure 3 shows a further modified form of the present invention. In this instance, the aerosol represented at 50 could be the aerosol between the junction 41 and the deposition chamber 11 of Figure 2. The aerosol would be provided as previously explained after air flow for purging the deposition chamber 11 before the wafer is put into place. After the atomizer 22 has been turned off the chamber 11A of Figure 3 can be purged with clean gas.

Single aerosol particles produced by atomization are usually electrically charged. Thus, it is possible to increase the rate of particle deposition by means of an applied electric field. In the deposition chamber 11A of Figure 3, a metal plate 52 is provided and it surrounds the inlet port 53. The plate 52 is connected to a high voltage power supply 54 to provide an electrical potential on the plate. The metal plate 52 is mounted on an insulating support, and connected so that it is electrically insulated from the deposition chamber 11A. The wafer 14 itself is connected to a ground connection through a line 55, which can connect through the wafer, or to the wafer support 12, as desired.

In this system, when the aerosol stream entering the chamber 11A impinges on the wafer 14 and the particles carried in the flow of the aerosol will have an electrostatic change applied, causing the rate of particle deposition to increase, thereby shortening the time required for particle deposition to achieve a known number of particles or particle density on the wafer 14.

The electrically charged plate 52 can be used with either of the systems shown in Figures 1 and 2, to further improve particle deposition by lessening the time needed for providing adequate deposition on a particular wafer 14.

The same procedure for deposition is used prior to the introduction of the aerosol into line 20, and also upon completion of the aerosol deposition, namely the purging of the chamber initially before the wafer 14 is put into place, and providing a clean gas flow over the wafer 14 after the deposition has been stopped.

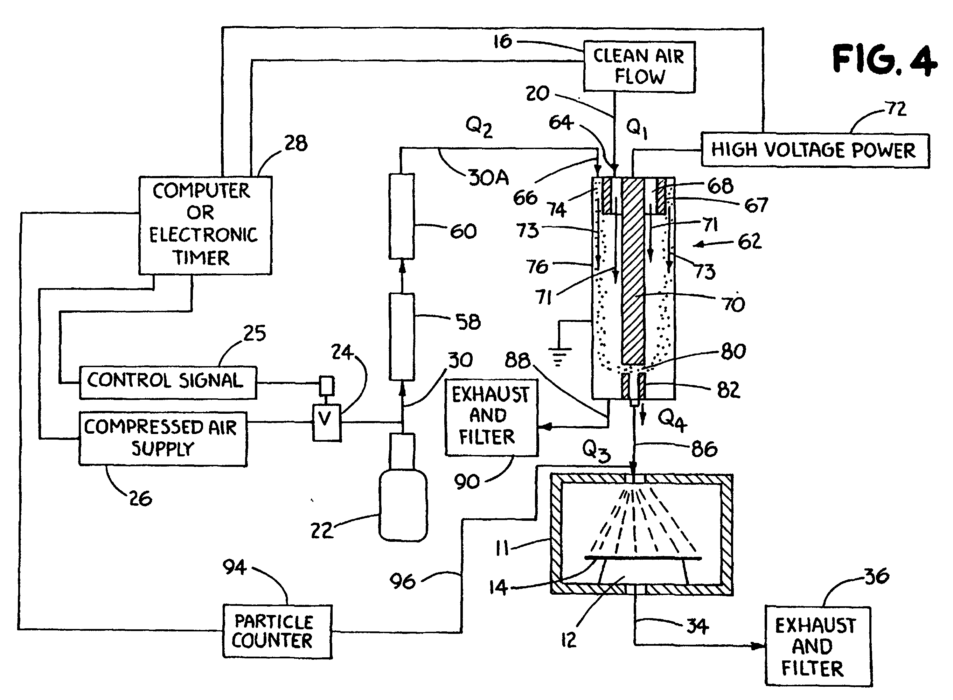

Figure 4 shows a further modified form of the present invention, again with like components being numbered the same as in Figures 1-3. In this form of the invention, the deposition chamber 11 is provided with an electrical aerosol switch on the inlet side of the chamber. In this instance, the clean air flow is provided from source 16 as previously explained, along the line 20. The clean gas or air flow volume is Q₁, as previously explained as well.

The atomizer 22 is connected through a line 30 to a conventional dryer 58. The flow through line 30 is controlled by the valve 24, and control signal 25 from the timer or computer 28 as previously explained as well. Compressed air supply 26 is provided through the valve 24. The dryer 58 is of conventional design which dries the liquid from the aerosol stream, and after passing through the conventional dryer 58, the aerosol, in dry air, is passed through an ionizer 60 which provides an electrical charge to the particles. The ionizer also is a conventional unit used in providing aerosols at the present time. Charged particles are discharged out through line 30A.

The electrical aerosol switch is indicated at 62. It is a cylindrical condenser in which laminar air flow is established. There are two input air streams. Flow Q₁ is input into the switch at a connection 64 near the center of the switch, and the flow Q₂, which is the input aerosol stream, is provided at an annular input junction 66 adjacent the periphery of the electrical switch 62.

Input air connection 64 for the clean air flow discharges air into an annular chamber or plenum 68, defined by a tubular wall 67 providing a baffle that surrounds a central electrode 70 in a housing 76. The tubular wall 67 also defines an annular chamber 74 inside housing 76, but to the outside of chamber 68. The aerosol input connection 66 leads to the annular chamber 74 that surrounds the chamber 68 so that as the clean air and the aerosol both flow downwardly as indicated by the arrows 71 and 73. The clean air flow is a core of air near the center, adjacent the electrode 70.

The electrode 70 is an inner cylindrical body and is connected to a high voltage power supply. The air flows Q₁ and Q₂ both flow down through the annular space between the central electrode 70 and the outer housing 76 of the electrical aerosol switch and stay relatively separate. That is, the flows do not substantially intermix. By applying a voltage to the electrode 70, which is an inner cylinder, the particles carried in flow Q₂ through the annular chamber 74 continue to move on the outside of the clean air flow, but are deflected across the clean air flow stream coming down around the outside of the electrode 70. The aerosol particles thus are attracted in toward the center electrode, and it is possible, by controlling the electrical field, to deflect particles of the desired diameter in the vicinity of a slit opening shown at 80 down near the bottom of the electrode 70 which is spaced slightly from an outlet tubular cylinder 82.

The cylinder 82 surrounds the outlet opening for air flow from the electrical aerosol switch. The particles attracted toward slit 80 are swept out of the switch by the output aerosol stream indicated at Q₄ along the line 86 leading to the deposition chamber 11. Proper size particles are carried with the flow into the deposition chamber 11. Excess aerosols are contained in an exhaust stream Q₃ coming from outlet passage 88 of the housing 76 into an exhaust filter arrangement 90.

The electrical aerosol switch 62 described above has been used as an electrostatic particle classifier for producing a monodisperse aerosol from an aerosol that is initially polydisperse. This structure is subject of a descriptive article by the present inventor Benjamin Liu, and D.Y.H. Pui entitled "A SUBMICRON AEROSOL STANDARD AND THE PRIMARY, ABSOLUTE CALIBRATION OF THE CONDENSATION NUCLEI COUNTER" J. Colloid Interface Sci. 47:155-171, 1974. However, adapting this type of a classifier to the input side of the deposition chamber 11 gives a great advantage in being able to provide a known size particle and since the flow through the narrow slit 80 of the particles is controlled by the voltage being applied to the electrode 70, the monodisperse aerosol particles can be switched into the deposition chamber 11 or stopped from entering the deposition chamber 11 very rapidly to give a very precise control to the deposition of particles on the wafer 14.

The aerosol produced by the atomizer 22 in this case can be a polydisperse aerosol, and the electrical aerosol switch 62 acts as a classifier to provide a monodisperse aerosol into the particle deposition chamber 11.

Laminar flow is achieved in the cylindrical housing for the electrical aerosol switch 62, and it is used in its traditional role as a particle classifier. However, the additional use as an aerosol switch because of the narrow slit opening that permits a particle to enter only when the electrode is energized, makes it possible to maintain a steady air flow Q₄ into the deposition chamber 11 while quickly switching the particles into or out of the stream for precise deposition time control. In other words, there will always be an air flow through the gap 80 into the deposition chamber 11 when the system is operating, but particles will only be entering that gap when the electrode 76 is on.

In Figure 4 a particle counter 94 can be provided through a line 96 as an option which can be incorporated into the system when desired to count the particles coming in the line 86 and thus into the deposition chamber 11.

The electrical switch 62 also can be used strictly as a particle classifier by controlling the stream of the aerosols through operation of the valve 24 as previously explained while maintaining a steady high voltage on the electrode 70, so that laminar flow in the cylindrical housing 76 will still be maintained, but the timing of particle introduction would then be controlled by the valve 24 operating atomizer 22 inasmuch as the electrode 70 would then be continuously energized.

The output of the airborne particle counter can be used as a signal for the automatic adjustment of the deposition time through the timer or computer 28 as desired.

Automatic adjustment of the deposition time can be determined by the particle count of particles entering the deposition chamber 11, for deposition onto the wafer 14. An electronic controller also can be used and controlled by the particle counter output.

The optional airborne particle counter 94 also can be used with the system shown in Figures 1 and 2 to provide automatic particle deposition control.

The system thus provides for the advantages of having a clean air flow that purges the chamber to eliminate unwanted particles from the chamber prior to the time the wafer is introduced, and then controlling the particles being introduced into the chamber to a selected range of sizes for a precise time to deposit the necessary number of particles on the wafer surface. The particles can be shut off in response to a timer, or after a desired particle count as shown as well.

The use of a sheath of clean air after the particles have been deposited on the wafer 14 also ensures that unwanted particles may not be deposited on the wafer as it is being removed from the deposition chamber.

Although the present invention has been described with reference to preferred embodiments, workers skilled in the art will recognize that changes may be made in form and detail without departing from the scope of the invention as defined by the claims.

## Claims

1. A system (10) for depositing particles of known size from a supply thereof onto a surface e.g. of a wafer, the system comprising a deposition chamber (11) having an inlet (53) and an outlet (34);
a support (12) provided in the deposition chamber for mounting a wafer or other element thereon;
a source (16) of clean gas coupled for introduction of clean gas into the deposition chamber (11);
supply means (22, 24, 26) for supply of a gas in the form of an aerosol (32) comprising said particles of known size, the supply means being coupled to direct said gas into the deposition chamber (11) for deposition of said particles as aforesaid; and
means (18, 24) for controlling the flows of the clean gas and said gas comprising said particles;
**characterized in that**
the source (16) of clean gas and the supply means (22, 24, 26) are coupled to the one inlet (53) for introduction of clean gas and/or said gas into the chamber (11) and **in that** the clean gas, during operation of the system, purges unwanted impurities before and after introduction of said gas comprising said particles into the chamber (11).

2. A system according to Claim 1 wherein said means (18, 24) for controlling the flow of the clean gas and said gas comprising said particles provides a clean gas flow towards the support (12), and a wafer (14) when mounted thereon, to purge unwanted impurities therefrom;
said supply means (22, 24, 26) supplies said gas in the form of an aerosol for a predetermined time in order to deposit a predetermined number of said particles as aforesaid; and
said means (18, 24) for controlling said flows admixes the flows for a predetermined period of time to deposit the predetermined number of particles and thereafter to direct the clean gas into the deposition chamber (11) to purge the chamber.

3. A system according to Claim 1 or Claim 2 and comprising counting means (94) for counting said particles of known size which are introduced into the deposition chamber (11), said counting means (94) being coupled to said means for controlling so as to control particle introduction into the deposition chamber (11).

4. A system according to any one of Claims 1 to 3 wherein means (52, 54) is provided for causing said particles of known size to acquire an electrostatic charge, and means (70) is provided for generating an electric field to deposit charged particles within the deposition chamber.

5. A system according to any one of Claims 1 to 4 wherein means (28, 48, 44) is provided for controlling total gas flow into the deposition chamber at a substantially constant volume.

6. A system according to Claim 5 wherein the means (28, 48, 44) for controlling the total gas flow into the chamber (11) is arranged to do so after introduction of said gas in aerosol form to maintain substantially a volume of gas flow into the deposition chamber (11) substantially the same as a volume of gas flow into the chamber (11) prior to adding said gas in aerosol form.

7. A system according to any one of Claims 1 to 6 and further comprising a particle classifier (62) receiving gas from said supply means (26) and classifying the particles therefrom prior to introduction into the deposition chamber (11).

8. A system according to Claim 4 or any of Claims 5 to 7 as dependent thereon, wherein said particle classifier (62) comprises an electrostatic classifier providing for a laminar flow of two gases, one comprising the clean gas flow (20), and the other comprising the aerosol containing said particles, the classifier (62) being arranged to provide an electrostatic charge on the particles to move the particles from the flow containing particles through the clean gas flow and into the deposition chamber (11).

9. A system according to any one of Claims 1 to 8 wherein said supply means comprises an atomiser (22) and a valve (24) to control flow of compressed air into the atomiser (22), for subsequent discharge of the aerosol from the atomizer (22) into a feedline carrying the clean gas to the inlet (53).

10. A system according to Claim 8 and further comprising an electrostatic switch (62) for controlling particles entering the deposition chamber (11) and connected to both the clean gas flow (16) and the aerosol flow (30A).

11. A system according to Claim 10 wherein the electrostatic switch (62) comprises a cylindrical housing (76) having an electrode (70) extending lengthwise in the housing, an annular aperture (68) defined by the electrode (70) and an annular baffle (67) provided at one end of the housing through which aperture clean gas can flow and move along the electrode, the annular baffle (67) and the housing (76) providing a further aperture (74) through which said gas in aerosol form can flow in laminar manner relative to the flow of clean gas, the inlet (53) to the deposition chamber (11) being connected to an outlet (82) from said cylindrical housing at that end thereof opposite from said aperture and said further aperture, the electrode (70) being charged to cause passage of particles of known size contained in the aerosol flow across the flow of clean gas and to the deposition chamber through said inlet (53).

12. A system according to Claim 11 wherein said outlet (82) is defined by a control slit in the cylindrical housing (76) for permitting only particles that are attracted by the electrode to enter the slit to be discharged into the deposition chamber (11).

13. A system according to any one of Claims 1 to 10 and further comprising a power source (54) for providing an electric field to affect the deposition of particles entering the deposition chamber (11), said power source (54) being connected to a metal electrode (52) in the deposition chamber (11).

14. A method of operating a system according to Claim 1 such that a predetermined number of said particles can be deposited into the deposition chamber (11) for deposition onto the surface (14) of a semiconductor wafer or other surface when provided on said support (12), the method comprising the steps of
directing a clean gas flow (16) through said inlet (53) into the deposition chamber (11) and at such surface to purge unwanted particles therefrom;
directing said gas flow (66) containing said particles through said inlet (53) into the deposition chamber (11) for a predetermined time to deposit a desired number of particles onto said surface (14) and then discontinuing the gas flow containing said particles; and
directing a clean gas flow (16) into the chamber (11) for a selected time after discontinuing gas flow (66) containing said particles, and prior to removal of a wafer (14) from the deposition chamber (11) when a wafer (14) is mounted on the support (12).

15. The method of Claim 14 including the step of counting (94, 96) the particles from the supply means (22, 24, 26) being introduced into the deposition chamber (11) for controlling particle introduction.

16. The method of Claim 14 wherein the particles from the source carry an electrostatic charge, and an electric field (70) is used to deposit the charged particles in the deposition chamber (11).

17. The method of Claim 14 including the step of controlling (28, 48, 44) a total gas flow into the deposition chamber (11) at a substantially constant volume during the steps of the method.

18. The method of Claim 14 including the steps of adding an aerosol flow (Q2) to the flow of clean gas (Q1), and controlling (28, 48, 44) the total gas flow into the chamber after adding the aerosol flow to maintain substantially a volume of gas flow into the deposition chamber (11) substantially the same as a volume of gas flow into the chamber prior to adding the aerosol flow.

19. The method of Claim 14 including the step of providing a particle classifier (62) receiving the gas flow containing particles from the supply means (22, 24, 26) and classifying the particles from the source prior to introduction into the deposition chamber.

20. The method of Claim 19 wherein said classifying step comprises utilizing an electrostatic classifier (62) having a laminar flow of two gases, one comprising the clean gas flow, and the other comprising the flow containing particles, and providing an electrostatic charge on the particles to move the particles from the flow containing particles through the clean gas flow and into the deposition chamber (11).

## Patentansprüche

1. System (10) zum Aufbringen von Partikeln bekannter Größe von einer Versorgungseinrichtung auf eine Oberfläche, beispielsweise einen Wafer, wobei das System Folgendes aufweist:
eine Aufbringungskammer (11) mit einer Einlassöffnung (53) und einer Auslassöffnung (34);
einen in der Aufbringungskammer vorgesehenen Träger (12) zum Befestigen eines Wafers oder eines anderen Bauelements auf diesem;
eine Reingas-Quelle (16), die zur Einleitung von Reingas in die Aufbringungskammer (11) angeschlossen ist;
eine Versorgungseinrichtung (22, 24, 26) zum Zuführen von Gas in Form eines Aerosols (32), das die Partikel bekannter Größe aufweist, wobei die Versorgungseinrichtung zur Leitung des Gases in die Aufbringungskammer (11) zum Aufbringen der Partikel wie zuvor erwähnt angeschlossen ist; und
eine Vorrichtung (18, 24) zum Steuern der Reingas-Ströme und des die Partikel enthaltenden Gases;
**dadurch gekennzeichnet, dass**
die Reingas-Quelle (16) und die Versorgungseinrichtung (22, 24, 26) an die eine Einlassöffnung (53) zum Einleiten des Reingases und/oder des Gases in die Kammer (11) angeschlossen sind, und dass das Reingas während des Betriebs des Systems unerwünschte Verunreinigungen beseitigt, bevor und nachdem das die Partikel enthaltende Gas in die Kammer (11) eingeleitet wird.

2. System nach Anspruch 1, **dadurch gekennzeichnet, dass** die Vorrichtung (18, 24) zum Steuern des Reingae-Stroms und des die Partikel enthaltenden Gases einen Reingas-Strom in Richtung zu dem Träger (12) und zu einem Wafer (14), falls dieser auf dem Träger befestigt ist, schafft, um unerwünschte Verunreinigungen zu eliminieren;
wobei die Versorgungseinrichtung (22, 24, 26) das Gas in der Form eines Aerosols über eine bestimmte Zeitdauer liefert, um eine vorbestimmte Anzahl dieser Partikel wie zuvor beschrieben aufzubringen; und
die vorrichtung (18, 24) zum Steuern der Ströme die Gasströme über eine bestimmte Zeitdauer vermischt, um die vorbestimmte Anzahl an Partikeln aufzubringen und anschließend das Reingas in die Aufbringungskammer (11) zu leiten, damit dieses die Kammer reinigt.

3. System nach Anspruch 1 oder 2, das ferner eine Zähleinrichtung (94) zum Zählen der in die Aufbringungskammer (11) eingebrachten Partikel bekannter Größe aufweist, wobei die Zähleinrichtung (94) an die Steuervorrichtung angeschlossen ist, so dass die Einbringung der Partikel in die Aufbringungskammer (11) gesteuert wird.

4. System nach einem der Ansprüche 1 bis 3, **dadurch gekennzeichnet, dass** eine Vorrichtung (52, 54) vorgesehen ist, die bewirkt, dass die Partikel bekannter Größe eine elektrostatische Aufladung erlangen, und eine Vorrichtung (70) zur Erzeugung eines elektrischen Feldes vorgesehen ist, um die geladenen Partikel innerhalb der Aufbringungskammer aufzubringen.

5. vorrichtung nach einem der Ansprüche 1 bis 4, **dadurch gekennzeichnet, dass** eine Vorrichtung (28, 48, 44) zum Steuern des gesamten Gasstroms in die Aufbringungskammer bei einem im Wesentlichen, konstanten Volumen vorgesehen ist.

6. System nach Anspruch 5, **dadurch gekennzeichnet, dass** die Vorrichtung (28, 48, 44) zum Steuern des Gesamtgasflusses in die Kammer (11) so ausgelegt ist, dass sie dies tut, nachdem das Gas in Form eines Aerosols eingeleitet worden ist, um im Wesentlichen ein Gasstromvolumen in die Aufbringungskammer (11) beizubehalten, das im Wesentlichen identisch mit einem Gasstromvolumen in die Kammer (11) vor dem Hinzufügen des Gases in Form eines Aerosols ist.

7. System nach einem der Ansprüche 1 bis 6, das ferner einen Partikel-Klassifizierer (62) aufweist, der Gas von der Versorgungseinrichtung (26) erhält und die Partikel von dieser vor dem Einbringen in die Aufbringungskammer (11) klassifiziert.

8. System nach Anspruch 4 oder einem der Ansprüche 5 bis 7 als von diesem abhängige Ansprüche, **dadurch gekennzeichnet, dass** der Partikel-Klassifizierer (62) einen elektrostatischen Klassifizierer aufweist, der für eine Laminaretrömung zweier Gase sorgt, wobei eine davon den Reingasstrom (20) aufweist, und die andere das die Partikel enthaltene Aerosol, wobei der Klassifizierer (62) so ausgelegt ist, dass er eine elektrostatische Ladung der Partikeln schafft, um die Partikel aus dem Partikel enthaltenen Strom durch den Reingasstrom und in die Aufbringungskammer (11) zu bewegen.

9. System nach einem der Ansprüche 1 bis 8, **dadurch gekennzeichnet, dass** die Versorgungseinrichtung einen Zerstäuber (22) und ein Ventil (24) zum Steuern des Druckluftstroms in den Zerstäuber (22) aufweist, um das Aerosol anschließend aus dem Zerstäuber (22) in eine Versorgungsleitung auszustoßen, das das Reingas zur Einlassöffnung (53) führt.

10. System nach Anspruch 8, das ferner einen elektrostatischen Schalter (62) zum Steuern von Teilchen aufweist, die in die Aufbringungskammer (11) eintreten und sowohl mit dem Reingasstrom (16) als auch dem Aerosolstrom (30A) verbunden ist.

11. System nach Anspruch 10, **dadurch gekennzeichnet, dass** der elektrostatische Schalter (62) ein zylindrisches Gehäuse (76), das eine sich in Längsrichtung in dem Gehäuse erstreckende Elektrode (70), und eine durch die Elektrode (70) und einem ringförmigen Ablenkblech (67) definierte ringförmige Öffnung (68) aufweist, die an einem Ende des Gehäuses vorgesehen ist und durch welche Reingas strömen und sich entlang der Elektrode bewegen kann, wobei das ringförmige Ablenkblech (67) und das Gehäuse (76) eine weitere Öffnung (74) schaffen, durch die das Gas in Form eines Aerosols laminar relativ zum Strom des Reingases fließen kann, wobei die Einlassöffnung (53) der Aufbringungskammer (11) mit einer Auslassöffnung (82) des zylindrischen Gehäuse an dessen einem Ende verbunden ist, das der Öffnung und der weiteren Öffnung gegenüberliegt, wobei die Elektrode (70) geladen ist, um den Durchstrom von Partikeln bekannter Größe, die in dem Aerosolstrom enhalten sind, durch den Strom des Reingases und zu der Aufbringungskammer durch die Einlassöffnung (53) zu bewirken.

12. System nach Anspruch 11, **dadurch gekennzeichnet**, daes die Auslassöffnung (82) durch einen Steuerungsschlitz in dem zylindrischen Gehäuse (76) definiert ist, um nur den Einlass derjenigen Partikel in den Schlitz zu ermöglichen, die von der Elektrode angezogen werden und die dann in die Aufbringungskammer (11) ausgestoßen werden sollen.

13. System nach einem der Ansprüche 1 bis 10, das ferner eine Energiequelle (54) zum Schaffen eines elektrischen Felds aufweist, damit die Aufbringung der in die Aufbringungskammer (11) eintretenden Partikel beeinflusst wird, wobei die Energiequelle (54) an eine Elektrode aus Metall (52) in der Aufbringungskammer (11) angeschlossen ist.

14. Verfahren zum Betreiben eines System gemäß Anspruch 1, so dass eine vorbestimmte Anzahl der Partikel in die Aufbringungskammer (11) eingebracht werden kann, um auf die Oberfläche (14) eines Halbleiter-Wafers oder auf eine andere Oberfläche aufgebracht zu werden, wenn diese auf dem Träger vorgesehen ist, wobei das Verfahren die folgenden Schritte umfasst:
das Lenken eines Reingas-Stroms (16) durch die Einlassöffnung (53) in die Aufbringungskammer (11) und auf eine solche Oberfläche, um unerwünschte Partikel von dieser zu eliminieren;
das Lenken des die Partikel enthaltenden Gasstroms (66) durch die Einlassöffnung (53) in die Aufbringungskammer (11) über eine vorbestimmte Zeitdauer, um eine gewünschte Anzahl an Partikeln auf die Oberfläche (14) aufzubringen, und anschließendes Unterbrechen des die Partikel enthaltenden Gasstroms; und
das Lenken eines Reingas-Stroms (16) in die Kammer (11) über einen gewählten Zeitraum nach der Unterbrechung des die Partikel enthaltenden Gasstroms (66) und vor dem Herausnehmen eines Wafers (14) aus der Aufbringungskammer (11), wenn ein Wafer (14) auf dem Träger (12) befestigt ist.

15. Verfahren nach Anspruch 14, das den Schritt des Zählens (94, 96) der Partikel von der Versorgungseinrichtung (22, 24, 26) einschließt, wobei der Schritt eingesetzt wird, um in der Aufbringungskammer (11) den Partikeleintritt zu steuern.

16. Verfahren nach Anspruch 14, **dadurch gekennzeichnet, dass** die Partikel von der Versorgungsquelle eine elektrostatische Ladung tragen, und ein elektrisches Feld (70) zum Aufbringen der geladenen Partikel in der Aufbringungskammer (11) eingesetzt wird.

17. Verfahren nach Anspruch 14, das den Schritt der Steuerung (28, 48, 44) des Gesamt-Gasstroms in die Aufbringungskammer (11) bei einem im Wesentlichen konstanten Volumen während der Schritte des Verfahrens einschließt.

18. Verfahren nach Anspruch 14, das die Schritte des Hinzufügens eines Aerosol-Stroms (Q2) zum Reingas-Strom (Q1) einschließt, sowie das Steuern (28, 48, 44) des Gesamt-Gasstroms in die Kammer nach dem Hinzufügen des Aerosol-Stroms, um im Wesentlichen ein Gasstromvolumen in die Aufbringungskammer (11) aufrechtzuerhalten, das im Wesentlichen identisch mit einem Gasstromvolumen in die Kammer vor dem Hinzufügen des Aerosol-Stroms ist.

19. Verfahren nach Anspruch 14, das den Schritt des Vorsehens eines Partikel-Klassifizierers (62) einschließt, der den die Partikel enthaltenden Gasstrom von der Versorgungseinrichtung (22, 24, 26) empfängt und die Partikel von der Quelle vor dem Einführen in die Aufbringungskammer klassifiziert.

20. Verfahren nach Anspruch 19, **dadurch gekennzeichnet, dass** der Klassifizier-Schritt die Verwendung eines elektrostatischen Klassifizieres (62) aufweist, der einen Laminarstrom bestehend aus zwei Gasen besitzt, wobei einer den Reingas-Strom und der andere den die Partikel enthaltenden Strom aufweist, und ferner eine elektrostatische Ladung auf Partikeln bewirkt, um die Partikel von dem die Partikel enthaltenden Strom durch den Reingas-Strom und in die Aufbringungskammer (11) zu bewegen.

## Revendications

1. Un système (10) pour déposer des particules de taille connue depuis un dispositif d'alimentation en particules sur une surface, par exemple sur une plaquette, le système comprenant une chambre de déposition (11) ayant une entrée (53) et une sortie (34) ;
un support (12) prévu dans la chambre de déposition pour monter une plaquette ou un autre élément sur lui ;
une source (16) de gaz propre, couplée pour introduire du gaz propre dans la chambre de déposition (11) ;
des moyens d'alimentation (22, 24, 26) pour fournir un gaz sous la forme d'un aérosol (32), comprenant lesdites particules de taille connue, les moyens d'alimentation étant couplés pour diriger ledit gaz dans la chambre de déposition (11) pour déposition desdites particules tel qu'indiqué ci-dessus ; et
des moyens (18, 20) pour commander les écoulements de gaz propre et dudit gaz comprenant lesdites particules ;
**caractérisé en ce que**
la source (16) de gaz propre et les moyens d'alimentation (22, 24, 26) sont couplés à une entrée (53) pour introduction de gaz propre et/ou dudit gaz dans ladite chambre (11), et **en ce que** le gaz propre, pendant le fonctionnement du système, opère une purge des impuretés indésirables avant et après introduction dudit gaz comprenant lesdites particules dans la chambre (11)

2. Un système selon la revendication 1, dans lequel lesdits moyens (18, 24) pour commander l'écoulement de gaz propre et ledit gaz comprenant lesdites particules fournissent un écoulement de gaz propre allant vers le support (12), et une plaquette (14) lorsqu'elle est montée sur lui, afin d'opérer une purge des impuretés indésirables pour les en débarrasser ;
lesdits moyens d'alimentation (22, 24, 26) fournissent ledit gaz sous la forme d'un aérosol pour une durée prédéterminée afin de déposer un nombre prédéterminé desdites particules tel qu'indiqué ci-dessus ; et
lesdits moyens (18, 24) pour commander lesdits écoulements effectuent un mélange des écoulements pendant une durée prédéterminée pour déposer le nombre prédéterminé de particules et, ensuite, pour diriger le gaz propre dans la chambre de déposition (11) afin de purger la chambre.

3. Un système selon la revendication 1 ou la revendication 2 et comprenant des moyens de comptage (94) pour compter lesdites particules de taille connue qui sont introduites dans la chambre de dépositions (11), lesdits moyens de comptage (94) étant couplés aux dits moyens de commande pour commander l'introduction de particule dans la chambre de déposition (11).

4. Un système selon l'une quelconque des revendications 1 à 3, dans lequel des moyens (52, 54) sont prévus pour que lesdites particules de taille connue acquièrent une charge électrostatique, et des moyens (70) sont prévus pour générer un champ électrique pour déposer des particules chargées à l'intérieur de la chambre de déposition.

5. Un système selon l'une quelconque des revendications 1 à 4, dans lequel des moyens (28, 48, 44) sont prévus pour commander l'écoulement de gaz dans la chambre de déposition, à un volume sensiblement constant.

6. Un système selon la revendication 5, dans lequel les moyens (28, 48, 44) pour commander l'écoulement de gaz total dans la chambre (11) sont agencés pour le faire après introduction dudit gaz sous forme d'aérosol, afin de maintenir pratiquement un volume d'écoulement de gaz dans ladite chambre de déposition (11) sensiblement de la même valeur que le volume d'écoulement de gaz se produisant dans la chambre (11) avant d'ajouter ledit gaz sous forme aérosol.

7. Un système selon l'une quelconque des revendications 1 à 6, et comprenant en outre un trieur de particules (62) recevant du gaz provenant desdits moyens d'alimentation (26) et classant les particules en provenant, avant d'effectuer l'introduction dans la chambre de déposition (11).

8. Un système selon la revendication 4 ou l'une quelconque des revendications 5 à 7 en dépendant, dans lequel ledit trieur de particules (62) comprend un trieur électrostatique assurant un écoulement laminaire de deux gaz, l'un comprenant l'écoulement de gaz propre (20), et l'autre comprenant l'aérosol contenant lesdites particules, le trieur (62) étant agencé pour fournir une charge électrostatique sur les particules, afin de déplacer les particules pour qu'elles passent de l'écoulement contenant les particules, par l'écoulement de gaz propre, et pénètrent dans la chambre de déposition (11).

9. Un système selon l'une quelconque des revendications 1 à 8, dans lequel lesdits moyens d'alimentation comprennent un atomiseur (22) et une soupape (24) pour commander l'écoulement d'air comprimé dans l'atomiseur (22), pour effectuer une décharge subséquente de l'aérosol depuis l'atomiseur (22), dans une tuyauterie d'alimentation véhiculant le gaz propre vers l'entrée (53).

10. Un système selon la revendication 8 et comprenant en outre un interrupteur électrostatique (62) pour commander l'entrée des particules dans la chambre de déposition (11) et relier à la fois à l'écoulement de gaz propre (16) et à l'écoulement en aérosol (30A).

11. Un système selon la revendication 10, dans lequel l'interrupteur électrostatique (62) comprend un boîtier cylindrique (76) ayant une électrode (70) s'étendant dans la direction longitudinale du boîtier, une ouverture (68) annulaire définie par l'électrode (70) et un déflecteur (67) annulaire, prévu à une extrémité du boîtier, ouverture par laquelle du gaz propre peut s'écouler et se déplacer le long de l'électrode, le déflecteur annulaire (67) et le boîtier (76) fournissant une autre ouverture (74) par laquelle ledit gaz sous forme d'aérosol peut s'écouler à la façon d'un écoulement laminaire par rapport à l'écoulement de gaz propre, l'entrée (53) à la chambre de déposition (11) étant reliée à une sortie (82) venant dudit boîtier cylindrique, à une extrémité de celui-ci opposée à ladite ouverture et à ladite autre ouverture, l'électrode (70) étant chargée pour provoquer le passage de particules de taille connue contenues dans l'écoulement en aérosol dans l'écoulement de gaz propre et à la chambre de déposition, en passant par ladite entrée (53).

12. Un système selon la revendication 11, dans lequel ladite sortie (82) est définie par une fente de commande ménagée dans ledit boîtier (76) cylindrique, afin de permettre l'entrée par la fente pour une décharge dans la chambre de déposition (11), uniquement des particules ayant été attirées par l'électrode.

13. Un système selon l'une quelconque des revendications 1 à 10, et comprenant en outre une source de puissance électrique (54) pour fournir un champ électrique devant affecter la déposition des particules pénétrant dans la chambre de déposition (11), ladite source de puissance (54) étant reliée à une électrode métallique (52) dans la chambre de déposition (11).

14. Un procédé de fonctionnement d'un système selon la revendication 1, de manière qu'un nombre prédéterminé desdites particules puisse être déposé dans la chambre de déposition (11) pour déposition sur la surface (14) d'une plaquette à semi-conducteurs ou une autre surface lorsque elle est placée sur ledit support (11), le procédé comprenant les étapes consistant à :
diriger un écoulement de gaz propre (16) par ladite entrée (53) dans la chambre de déposition (11) et sur une surface telle qu'on produise une purge pour évacuer les particules indésirables ;
diriger ledit écoulement de gaz (66) contenant lesdites particules à travers ladite entrée (53) dans la chambre de déposition (11) pour une durée prédéterminée afin de déposer un nombre souhaité de particules sur ladite surface (14) et, ensuite, d'interrompre l'écoulement de gaz contenant lesdites particules ; et
diriger un écoulement de gaz propre (16) dans la chambre (11) pour une durée sélectionnée après l'interruption de l'écoulement de gaz (66) contenant lesdites particules, et avant l'enlèvement d'une plaquette (14) de la chambre de déposition (11) lorsqu'une plaquette (14) est montée sur le support (12).

15. Le procédé selon la revendication 14, comprenant l'étape de comptage (94, 96) des particules venant des moyens d'alimentation (22, 24, 26) introduits dans la chambre de déposition (11) pour commander l'introduction des particules.

16. Le procédé selon la revendication 14, dans lequel les particules venant de la source véhiculent une charge électrostatique et un champ électrique (70) est utilisé pour déposer les particules, ayant été chargées, dans la chambre de déposition (11).

17. Le procédé selon la revendication 14, comprenant l'étape de commande (28, 48, 44) d'un écoulement de gaz total dans la chambre de déposition (11), sous un volume pratiquement constant durant les étapes du procédé.

18. Le procédé selon la revendication 14, comprenant les étapes d'addition d'un écoulement en aérosol (Q2) à l'écoulement de gaz propre (Q1) et de commande (28, 48, 44) de l'écoulement de gaz total dans la chambre après addition de l'écoulement en aérosol, afin de conserver sensiblement un volume d'écoulement de gaz dans la chambre de déposition (11) à une valeur qui est pratiquement égale au volume d'écoulement de gaz dans la chambre avant l'addition de l'écoulement en aérosol.

19. Le procédé selon la revendication 14, comprenant l'étape de fourniture d'un trieur de particules (62) recevant l'écoulement de gaz contenant les particules venant des moyens d'alimentation (22, 24, 26) et triant les particules provenant de la source, avant l'introduction dans la chambre de déposition.

20. Le procédé selon la revendication 19, dans lequel ladite étape de tri comprend l'utilisation d'un trieur électrostatique (62) ayant un écoulement laminaire de deux gaz, l'un comprenant l'écoulement de gaz propre et l'autre comprenant l'écoulement contenant les particules, et la fourniture d'une charge électrostatique aux particules afin de déplacer les particules de l'écoulement contenant les particules, par l'écoulement de gaz propre, et pour le faire s'introduire dans la chambre de déposition (11).
